Europäisches Patentamt

European Patent Office

Office européen des brevets

(19)

(11) Numéro de publication: **0 274 035**
**B1**

(12)

# FASCICULE DE BREVET EUROPEEN

(45) Date de publication du fascicule du brevet: 23.01.91

(51) Int. Cl.⁵: **G 04 C 3/00,** H 03 K 5/01

(21) Numéro de dépôt: **87117190.6**

(22) Date de dépôt: **21.11.87**

(54) Circuit de mise en forme du signal produit par un contact.

(30) Priorité: **03.12.86 CH 4822/86**

(43) Date de publication de la demande:
**13.07.88 Bulletin 88/28**

(45) Mention de la délivrance du brevet:
**23.01.91 Bulletin 91/04**

(84) Etats contractants désignés:
**CH DE FR GB LI**

(56) Documents cités:
**CH-A- 4 130**
**FR-A-2 380 581**
**GB-A-2 005 876**
**US-A-3 989 960**

(73) Titulaire: **ETA SA Fabriques d'Ebauches**
**Schild-Rust-Strasse 17**
**CH-2540 Granges (CH)**

(72) Inventeur: **Soltermann, Bertrand**
**Route de Lamboing 42**
**CH-2517 Diese (CH)**

(74) Mandataire: **de Raemy, Jacques et al**
**ICB Ingénieurs Conseils en Brevets SA Passage**
**Max. Meuron 6**
**CH-2001 Neuchâtel (CH)**

Courier Press, Leamington Spa, England.

## Description

Il est bien connu qu'un contact mécanique, en particulier de montre, pouvant occuper une position ouverte et une position fermée, ne passe pas d'une position l'autre sans subir des rebondissements, ces rebondissements altérant bien entendu le signal produit par le contact.

La présente invention concerne un circuit qui fournit, en réponse au signal délivré par un contact perturbé par des rebondissements, un signal bien défini représentatif de la position de ce contact.

De tels circuits, appelés aussi circuits d'antirebondissement, sont bien connus. Dans une forme de réalisation le circuit comporte une bascule monostable dont la sortie délivre un signal de durée déterminée en réponse à la première fermeture (ou la première ouverture) du contact. Dans ces conditions, les rebondissements du contact qui suivent immédiatement l'établissement du signal n'ont plus aucun effet sur ce signal si sa durée est supérieure à la durée du passage du contact d'une position stabilisée à l'autre position stabilisée et correspondant à la durée de basculement du contact. Bien entendu cette durée varie en sens inverse de la fréquence de travail du contact, c'est-à-dire de la fréquence de ses changements de position.

Ce type de circuit donne des résultats satisfaisants dans les applications courantes, c'est-à-dire lorsqu'il est associé à un contact présentant une durée de basculement sensiblement constante, que des chocs extérieurs ne viennent pas perturber. Dans le cas contraire, un tel circuit pourra donner des informations erronées.

En effet, si la durée de basculement du contact est variable et dépasse la durée du signal fourni par le circuit, les rebondissements pourront déclencher encore un ou plusieurs signaux indésirables, fournissant de fausses informations. De tels signaux parasites seront aussi produits par le circuit si le contact passe d'une position à l'autre, alors qu'il se trouve au repos, à la suite, par exemple, de chocs accidentels d'intensité suffisante. Enfin, il peut encore se présenter le cas où la fréquence de travail du contact est suffisamment élevée pour que le signal de sortie du circuit recouvre, sans les distinguer, plusieurs changements de position du contact. Le circuit, dans ce cas, fournira également une information incorrecte.

Or, de telles conditions extrèmes de travail peuvent se présenter, en particulier, pour certains contacts utilisés dans les montres. C'est, par exemple, le cas des montres électroniques analogiques pourvues d'un calendrier perpétuel et dont le circuit reçoit un signal journalier produit par un contact. Ce contact, généralement réalisé à l'aide de deux lames flexibles, est activé une fois par jour par une came disposée sur l'axe d'entraînement de l'aiguille des heures. En fonctionnement normal, le contact est fermé par la came une fois par jour, le temps de basculement séparant les instants où les lames du contact commencent de se toucher de celui où elles se touchent de façon sûre étant de l'ordre de 30 minutes. En mode de correction, par contre, le contact travaille à une fréquence beaucoup plus élevée car il est activé manuellement par l'intermédiaire de la couronne de la montre, la couronne étant alors liée cinématiquement à l'axe de l'aiguille des heures. Le contact peut, dans ce cas, être activé plusieurs fois par minute, le temps d'interaction entre les lames étant alors réduit à quelques secondes. Il est évident qu'un circuit du type à bascule monostable ne peut être utilisé lorsque les conditions de fonctionnement varient entre de telles limites.

D'autre part, pour gagner de la place et réduire le couple sur la came, il est avantageux de choisir des lames souples, travaillant sur une faible course. Ceci rend, bien entendu, le contact particulièrement sensible aux chocs, contre lesquels une bascule monostable ne présente aucune protection.

Dans une autre forme de réalisation, moins sensible aux perturbations produites par les chocs, décrite dans la demande CH 4130/74, le circuit d'antirebondissement comprend essentiellement un compteur de capacité N délivrant une fois rempli un signal à sa sortie, et un générateur fournissant un signal de fréquence fixe formé d'une suite d'impulsions. Lorsque le contact est fermé les impulsions sont appliquées à l'entrée du compteur, alors que durant l'ouverture du contact l'arrivée des impulsions est interrompue et le compteur est remis à zéro.

Dans ces conditions, lors du passage du contact de la position ouverte à la position fermée, chaque ouverture du contact produite par les rebondissements ou résultant d'un choc, remet le compteur à zéro. La fréquence de répétition des impulsions et le nombre N sont par ailleurs choisis de manière que pendant cette phase d'instabilité du contact le compteur ne puisse pas recevoir N impulsions consécutives. Ce n'est qu'après le dernier rebondissement, alors que le contact est fermé avec une pression suffisante pour ne plus être sensible aux chocs, que le compteur, après avoir compté N impulsions, délivre un signal représentatif de la position fermée du contact.

Si le deuxième circuit donne une information sur la position du contact plus sûre que le premier lorsque la fréquence de travail du contact est fixe, par contre les deux circuits présentent les mêmes insuffisances quand cette fréquence varie dans de fortes proportions.

La présente invention a pour but de pallier cet inconvénient en proposant un circuit de mise en forme du signal produit par un contact, ce signal pouvant se trouver dans un premier ou un deuxième état, un état correspondant à la position ouverte du contact et l'autre état à la position fermée de ce contact, contact qui est susceptible d'effectuer des rebondissements lors de son passage d'une position à l'autre, comportant:

des moyens pour produire un signal de référence formé d'une suite d'impulsions, la fréquence de répétition des impulsions étant supérieure à la fréquence des changements de position du contact;

des moyens pour compter les impulsions;

des moyens pour commander l'application des impulsions aux moyens de comptage lorsque le signal du contact se trouve dans son premier état, et interrompre cette application lorsque le signal se trouve dans son deuxième état;

des moyens pour remettre à zéro les moyens de comptage lorsque le signal du contact se trouve dans son deuxième état; et

des moyens pour produire un signal de sortie lorsque le nombre d'impulsions comptées par lesdits moyens de comptage atteint une valeur prédéterminée, qui est particulièrement remarquable en ce que les moyens pour produire le signal de référence comportent des moyens pour augmenter et pour diminuer la fréquence de répétition des impulsions de ce signal lorsque la fréquence des changements de position du contact augmente et respectivement diminue.

D'autres caractéristiques et avantages du circuit selon la présente invention ressortiront de la description qui va suivre, faite en regard du dessin annexé et donnant, à titre explicatif mais nullement limitatif, une forme de réalisation d'un tel circuit. Sur ce dessin, où les mêmes références se rapportent à des éléments analogues:

la figure 1 est une vue montrant un contact associé à une came de commande rotative;

la figure 2 est un schéma représentant une forme de réalisation du circuit selon l'invention; et

la figure 3 est un diagramme montrant la forme de certains signaux produits par le contact et le circuit.

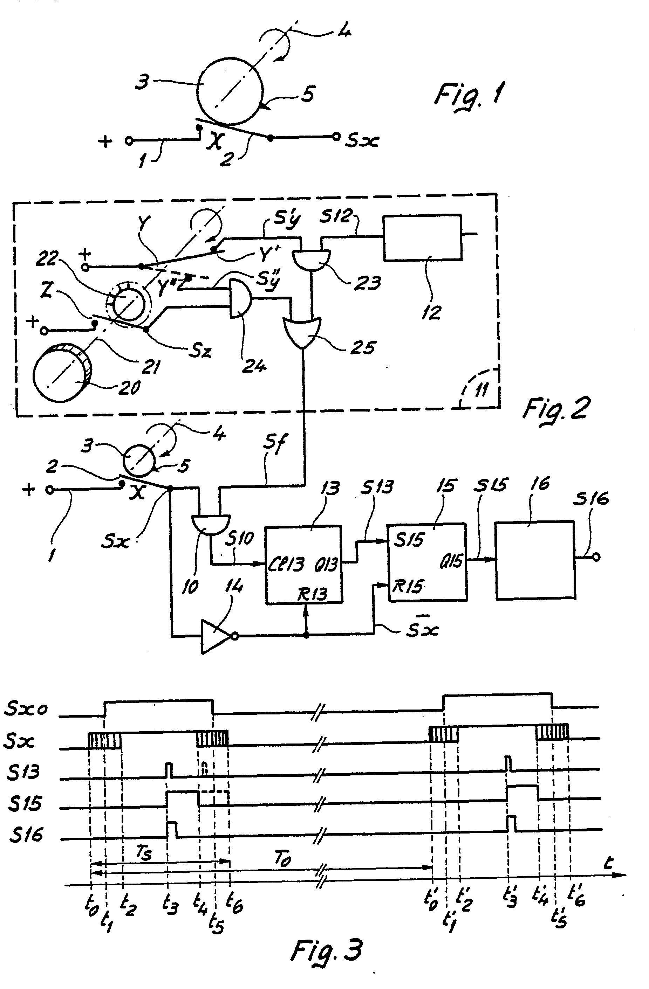

Un contact mécanique conventionnel, référencé X, est représenté sur la figure 1. Il comprend une lame fixe 1 et une lame mobile 2, ne se touchant pas à l'état de repos. La commande du contact est obtenue à l'aide d'une came 3, entraînée en rotation par un axe 4 tournant dans un seul sens, et portant sur sa périphérie une dent 5. Dans son mouvement, la dent 5 déplace la lame 2 qui vient alors toucher la lame 1 pour faire passer le contact X de la position ouverte à la position fermée.

La lame 1 est portée à une tension positive. La lame 2 fournit alors un signal logique Sx qui se trouve au niveau bas lorsque le contact est ouvert, et au niveau haut lorsqu'il est fermé. La même convention sera utilisée pour les autres contacts qui seront décrits ultérieurement.

Dans le cas idéal, le contact X travaille sans rebondissement, produisant un signal Sxo qui est représenté sur la figure 3 en fonction du temps. La fermeture du contact a lieu aux instants $t_1, t'_1 \ldots$ et l'ouverture aux instants $t_5, t'_5 \ldots$ En supposant que la came 3 tourne à vitesse constante, les intervalles de temps $Tso =, t_5-t_1 = t'_5-t'_1$ et $T_o = t'_1-t_1$ définissent respectivement la durée du signal Sxo et sa période.

En réalité, la transition du contact X de la position ouverte à la position fermée et inversement n'est pas franche, mais présente une série de rebondissements autour des instants $t_1, t_5, t'_1, t'_5 \ldots$. Le signal Sx produit est représenté sur la figure 3. Ainsi la première fermeture du contact a lieu à un instant $t_o$, légèrement antérieur à $t_1$, et la fermeture franche à un instant $t_2$, légèrement postérieur à $t_1$. De même, l'ouverture du contact commence à un instant $t_4$ pour se terminer à un instant $t_6$, ces instants étant situés de part et d'autre de $t_5$. La durée du signal Sx vaut dans ce cas $Ts = t_6-t_o = t'_6-t'_o$ et elle est supérieure à Tso, alors que sa période $t'_o-t_o$ reste égale à $T_o$.

Si la came 3 est entraînée par l'axe des heures d'une montre alors, typiquement, Ts = 30 minutes, $t_2-t_o = t_6-t_4$ = 9 minutes, $t_4-t_2$ = 12 minutes et, bien entendu, $T_o$ = 12 heures. La came tourne dans ces conditions d'un angle de 15 degrés entre $t_1$ et $t_6$ et de 6 degrés entre $t_2$ et $t_4$. Ces valeurs montrent que la période d'instabilité représente une bonne partie de la durée de travail du contact. Des fermetures sporadiques du contact peuvent encore résulter, entre les instants $t_6$ et $t'_o$, de chocs extérieurs.

Ainsi que cela avait déjà été relevé, une bascule monostable, ayant une période de basculement légèrement supérieure à $t_6-t_o$, permettrait d'éliminer les rebondissements se produisant autour des instants $t_1$ et $t_5$. Par contre, en réagissant aux fermetures de contact consécutifs aux chocs, une telle bascule ne saurait fournir un signal fiable.

Pour cette raison c'est un circuit d'antirebondissement du type décrit dans le document CH 4130/74, déjà cité, qui est utilisé dans la présente réalisation. Afin de bien comprendre l'invention, ce circuit, représenté sur la figure 2, sera décrit en détail. On distingue sur la figure 2 le contact X, que l'on supposera faire partie d'une montre électronique analogique non-représentée, et la came 3 entraînée par l'axe 4 de l'aiguille des heures, à raison de 1 tour par 12 heures. Le signal Sx produit par le contact X est appliqué à une entrée d'une porte ET10 à deux entrées, l'autre entrée recevant un signal de référence Sf formé d'une suite de brèves impulsions. Le signal Sf est produit par un générateur d'impulsions 11 dont la description détaillée sera faite ultérieurement. Ce générateur peut avantageusement contenir le diviseur de fréquence 12 du circuit de la montre, et fournir sur une sortie un signal S12 formé d'impulsions de minute. On supposera pour le moment que le signal Sf est pris directement à la sortie du diviseur 12 et que par conséquent les signaux Sf et S12 sont identiques.

La sortie de la porte ET10 fournit un signal S10 qui est appliqué sur l'entrée d'horloge Cl13 d'un compteur à 3 bits, référencé 13. Ce compteur a encore une entrée de remise à zéro R13 et une sortie Q13 qui fournit un signal de débordement, appelé aussi overflow, référencé S13. Ce signal, représenté sur la figure 3, contient, par exemple, une brève impulsion qui apparaît chaque fois que le compteur atteint sa pleine capacité. Enfin, l'entrée R13 est reliée à la sortie d'un inverseur 14 dont l'entrée est connectée au contact X pour recevoir le signal Sx. Le compteur 13 est donc remis à zéro par un signal $\overline{Sx}$, inverse du signal Sx.

Le fonctionnement du circuit de la figure 2 est le suivant. Aussi longtemps que le contact X est ouvert, le signal Sx se trouve au niveau logique bas. Le signal Sf est alors bloqué par la porte ET10 et le compteur 13 remis à zéro, le signal $\overline{Sx}$ étant au niveau logique haut. La came 3, dans son mouvement de rotation, ferme le contact X à l'instant $t_0$ grâce à la dent 5, faisant passer le signal Sx au niveau logique haut et le signal $\overline{Sx}$ au niveau logique bas. Dans ces conditions la porte ET10 devient passante et le compteur 13 commence de compter les impulsions de minute du signal Sf.

A la première ouverture du contact X consécutive à un rebondissement, le compteur 13 est remis à zéro et le comptage est arrêté, pour reprendre depuis zéro dès la prochaine fermeture de ce contact. Ce processus pourra se répéter plusieurs fois entre les instants $t_0$ et $t_2$. La capacité du compteur 13 étant de 3 bits, il ne peut compter au maximum que jusqu'à 7. On supposera que, durant la période d'établissement du contact, il y a suffisamment de rebondissements pour que ce nombre ne soit jamais atteint.

A partir de l'instant $t_2$, le contact est supposé être fermé et ne plus subir de rebondissements. Le comptage des impulsions du signal Sf peut alors se poursuivre sans interruption pendant 7 minutes, soit jusqu'à l'instant $t_3$. Le contenu du compteur 13 atteignant à ce moment sa valeur maximum, la sortie Q13 produit une brève impulsion qui se retrouve dans le signal S13, indiquant que le contact X s'est fermé. Le comptage continue encore pendant 5 minutes jusqu'à l'instant $t_4$, instant où le compteur est remis à zéro par la première ouverture du contact X, avant d'avoir atteint une deuxième fois sa capacité maximum. Enfin, entre l'instant $t_4$ et l'instant $t_6$, où le contact est en phase d'ouverture, se reproduit exactement la même situation qu'entre les instants $t_0$ et $t_1$. On supposera dans ce cas aussi qu'il y a suffisamment de rebondissements pour que le compteur n'atteigne jamais sa capacité maximum.

Douze heures après $t_0$, soit à l'instant $t'_0$, le contact X recommencera le même cycle et sa fermeture sera identifiée de la même manière que précédemment par une impulsion du signal S13 survenant à l'instant $t'_3$.

Le circuit qui vient d'être décrit demande, pour fournir un signal de sortie, que le contact X reste fermé pendant 7 minutes consécutives. Il offre donc une protection très efficace contre de brèves fermetures du contact résultant de chocs extérieurs entre les instants $t_6$ et $t'_0$.

Il a été supposé, dans la description du fonctionnement du circuit, que le contact X s'ouvrait à l'instant $t_4$, soit 5 minutes après que le compteur 13 ait atteint sa capacité maximum et produise une impulsion à l'instant $t_3$. Si l'ouverture du contact tarde de plus de 2 minutes, le compteur continuant d'être incrémenté par le signal Sf, il atteindra encore une fois sa capacité maximum avant l'instant $t_6$, et produira une autre impulsion, représentée en traittillé sur la figure 3, entre les instants $t_4$ et $t_5$. Cette deuxième impulsion, n'ayant pas été produite par un changement de position du contact X, n'a pas la même signification que l'impulsion précédente, avec laquelle elle ne doit pas être confondue.

Pour éviter ce risque, le signal S13 peut avantageusement être appliqué à l'entrée de mise à l'état S15 d'une bascule bistable 15 dont l'entrée de remise à zéro R15 reçoit le signal $\overline{Sx}$. La sortie Q15 de cette bascule fournit alors un signal S15 qui n'est pas influencé par la deuxième impulsion du compteur 13. En effet, la bascule 15 est remise à zéro par les rebondissements du contact X entre les instants $t_0$ et $t_2$. Cette bascule est ensuite mise à l'état à l'instant $t_3$ par l'impulsion du signal S13, faisant passer le signal S15 du niveau logique bas au niveau logique haut. L'impulsion suivante du signal S13 ne fait que confirmer l'état de la bascule. Le signal S15 reste donc au niveau logique haut jusqu'à la prochaine ouverture du contact X, soit au plus tard à l'instant $t_6$. Les deux impulsions du signal S13 ont ainsi été transformées en une impulsion unique du signal S15. Cette impulsion débute à l'instant $t_3$, mais sa durée est mal définie. Une bascule monostable 16, connectée à la sortie de la bascule 15, permet d'éliminer cet inconvénient en fournissant un signal S16 formé d'impulsions de durée constante correspondant aux impulsions du signal S15.

Le fonctionnement du circuit a été décrit dans le cas où la came 3 tourne à vitesse constante, faisant 1 tour en 12 heures. Il est bien évident que si la vitesse change, les conditions de travail du circuit pourraient devenir incompatibles avec un fonctionnement correct. Par exemple, si la vitesse de rotation de la came double, les temps figurant sur la figure 3 doivent tous être divisés par deux, alors que le signal Sf continue d'être formé d'impulsions de minutes. Le contenu du compteur 13, dans ces conditions, ne pourra jamais atteindre sa capacité maximum car, au bout de 7 minutes, le contact X aura déjà commencé de s'ouvrir, remettant à zéro le compteur avant qu'il ait pu produire un signal de sortie.

Par contre, si en même temps, la fréquence du signal Sf est doublée de manière qu'il délivre deux impulsions par minute, le fonctionnement du circuit redevient normal. En effet, l'intervalle de temps $t_4$—$t_2$ est maintenant de 6 minutes, au lieu de 12, mais il correspond toujours à un angle de 6 degrés sur la came 3 et, sur ces 6 degrés, le signal Sf, ayant une fréquence double, fournit 12 impulsions, comme auparavant.

Donc, en asservissant la fréquence du signal Sf à la vitesse de rotation de la came 3, c'est-à-dire à la fréquence de travail du contact X, par des moyens connus en soi, le circuit fournit un signal de sortie correct, même si la fréquence de travail varie dans de fortes proportions.

Le contact X, commandé par l'axe de l'aiguille des heures par l'intermédiaire de la came 3, est un exemple de contact pouvant travailler à des fréquences très différentes.

La fréquence de travail basse, soit une seule fermeture en 12 heures, est celle qui a été considérée jusqu'à maintenant et qui correspond au mode normal de fonctionnement de la montre. Pour corriger manuellement la date du calendrier, la montre doit être mise dans un mode de correction dans lequel le contact X travaille, par contre, à une fréquence beaucoup plus élevée.

Le passage d'un mode à l'autre est obtenu à l'aide d'une couronne 20 qui est montée sur un axe de pivotement 21 pouvant occuper, ainsi que la couronne, deux positions axiales. La première position, celle représentée sur la figure 2, correspond au mode normal de fonctionnement de la montre, alors que la deuxième position, obtenue en tirant la couronne, correspond au mode de correction de la date.

Dans cette deuxième position la couronne 20 est reliée, par un train d'engrenages non- représenté, à l'axe de l'aiguille des heures pour l'entraîner en rotation, ainsi que le contact X, à une vitesse élevée.

La position axiale de la couronne 20 est identifiée à l'aide d'un contact inverseur Y, commandé par le déplacement axial de l'axe de pivotement 21 et pouvant occuper deux positions angulaires, référencées Y' et Y'', la première correspondant au mode normal et la deuxième au mode de correction. Sur l'axe 21 est encore fixée une came 22 comportant 12 dents, chacune de ces dents, quel que soit le mode, venant fermer l'une après l'autre un contact Z lorsque la couronne 20 est mise manuellement en rotation.

Le contact Y produit deux signaux, référencés S'y et S''y. Le signal S'y est au niveau logique haut et le signal S''y au niveau logique bas lorsque le contact Y est dans la position Y'. Les niveaux logiques sont inversés pour la position Y''. Enfin le contact Z produit un signal Sz qui passe au niveau logique haut à chaque fermeture de ce contact.

Une porte ET23 à deux entrées reçoit les signaux S12 et S'y, et une autre porte ET24 à deux entrées, les signaux Sz et S''y. Les sorties des portes ET23 et ET24 sont reliées aux entrées d'une porte OU25 à deux entrées, la sortie de cette porte fournissant le signal de référence Sf.

Les éléments référencés 12, 20 à 25, Y et Z forment le générateur d'impulsions 11 dont le fonctionnement est le suivant.

En mode normal, le contact Y occupant la position Y', le signal S'y se trouve au niveau logique haut et le signal S''y au niveau logique bas. La porte ET23 laisse alors passer le signal S12, tandis que la porte ET24 bloque le signal Sz. Le signal Sf est par conséquent, dans ce cas, identique au signal S12, comme cela avait été supposé lors de la description du fonctionnement du circuit associé au contact X.

En mode de correction, par contre, le signal Sf deviant identique au signal Sz car, dans ce cas, la porte ET23 bloque le signal S12 tandis que la porte ET24 laisse passer le signal Sz. Dans ce mode, une liaison mécanique, non représentée, est en outre établie entre les axes 4 et 21 pour permettre l'entraînement de l'aiguille des heures par la couronne 20. Il est avantageux de choisir cette liaison de manière que 1 tour de la couronne 20 entraîne une rotation de 6 degrés de l'axe 4, correspondant à un déplacement de 12 minutes de l'aiguille des heures. Comme la came 22 est pourvue de 12 dents, le signal Sz, donc le signal Sf, contiendra alors 12 impulsions par tour de couronne, c'est-à-dire par 12 minutes de déplacement de l'aiguille des heures, exactement comme dans le mode normal.

Toutefois les 6 degrés de rotation de l'axe 4 sont effectués en 12 minutes en mode normal, alors qu'en mode de correction cet angle peut être parcouru en 1 seconde, soit 720 fois plus rapidement. La fréquence de travail du contact varie èvidemment dans le même rapport.

Il est bien entendu que le circuit qui vient d'être décrit peut subir différentes modifications et se présenter sous d'autres variantes évidentes pour l'homme du métier, sans sortir du cadre de la présente invention.

En particulier il peut avantageusement être adapté, grâce à l'utilisation d'un compteur avant-arrière et de moyens de détection connus du sens de rotation de la couronne, à un contact X dont la came de commande est susceptible de tourner dans les deux sens afin que la mise à la date puisse également être faite dans les deux sens.

## Revendications

1. Circuit de mise en forme du signal (Sx) produit par un contact (X), ledit signal pouvant se trouver dans un premier ou un deuxième état, un état correspondant à la position ouverte du contact et l'autre état à la position fermée dudit contact qui est susceptible d'effectuer des rebondissements lors de son passage d'une position à l'autre, comportant:

des moyens (11) pour produire un signal de référence (Sf) formé d'une suite d'impulsions, la fréquence de répétition des impulsions étant supérieure à la fréquence des changements de position du contact (X);

des moyens (13) pour compter lesdites impulsions;

des moyens (10) pour commander l'application desdites impulsions aux moyens de comptage lorsque le signal (Sx) du contact (X) se trouve dans son premier état, et interrompre cette application lorsque ledit signal se trouve dans son deuxième état;

des moyens (14) pour remettre à zéro lesdits moyens de comptage lorsque le signal (Sx) du contact (X) se trouve dans son deuxième état; et

des moyens (Q13) pour produire un signal de sortie lorsque le nombre d'impulsions comptées par lesdits moyens de comptage atteint une valeur prédéterminée, caractérisé en ce que lesdits moyens (11) pour produire ledit signal de référence (Sf) comportent des moyens (20 à 25, Z) pour augmenter et pour diminuer la fréquence de répétition des impulsions de ce signal lorsque la fréquence des changements de position du contact augmente et respectivement diminue.

2. Circuit selon la revendication 1, caractérisé en ce que ledit contact (X) est commandé par une première came rotative (3), et en ce que lesdits moyens (11) pour produire ledit signal de référence (Sf) comprennent une deuxième came rotative (22), liée cinématiquement en rotation à la première came, et un contact de détection (Z) commandé par la deuxième came et fournissant ledit signal de référence (Sf).

3. Circuit selon la revendication 2, appliqué à une montre électronique analogique comportant une couronne rotative (20) de mise à l'heure, caractérisé en ce que lesdites première (3) et deuxième (22) cames sont entraînées en rotation par la couronne durant la mise à l'heure de la montre.

**Patentansprüche**

1. Schaltung zum Formen des von einem Kontakt (X) erzeugten Signals (Sx), das sich in einem ersten öder einem zweiten Status befinden kann, wobei ein Status der Offenstellung des Kontakts und der andere der Schließstellung des Kontakts entspricht, der beim Übergang von der einen in die andere Stellung Prellungen unterliegen kann, umfassend:

Mittel (11) zum Erzeugen eines Referenzsignals (Sf), gebildet von einer Impulsfolge, deren Wiederholfrequenz größer ist als die Frequenz der Stellungsänderungen des Kontakts (X),

Mittel (13) zum Zählen dieser Impulse,

Mittel (10) zum Bewirken des Anlegens dieser Impulse an die Zählmittel, wenn das Signal (Sx) des Kontakts (X) sich in seinem ersten Status befindet, und zum Unterbrechen dieses Anlegens, wenn das Signal sich in seinem zweiten Status befindet,

Mittel (14) zum Rücksetzen der Zählmittel auf Null, wenn das Signal (Sx) des Kontakts (X) sich in seinem zweiten Status befindet, und

Mittel (Q13) zum Erzeugen eines Ausgangssignals, sobald die von den Zählmitteln gezählte Impulsanzahl einen vorbestimmten Wert erreicht, dadurch gekennzeichnet,

daß die Mittel (11) zum Erzeugen des Referenzsignals (Sf) Mittel (20 bis 25, Z) umfassen zum Erhöhen bzw. Absenken der Wiederholfrequenz der Impulse dieses Signals, sobald die Frequenz der Stellungsänderungen des Kontakts ansteigt bzw. absinkt.

2. Schaltung nach Anspruch 1, dadurch gekennzeichnet, daß der Kontakt (X) von einem ersten drehbaren Nocken (3) gesteuert ist und daß die Mittel (11) zum Erzeugen des Referenzsignals (Sf) einen zweiten drehbaren Nocken (22), der mit dem ersten Nocken kinematisch drehverbunden ist, sowie einen Erfassungskontakt (Z) umfassen, der von dem zweiten Nocken gesteuert ist und das Referenzsignal (Sf) liefert.

3. Schaltung nach Anspruch 2, angewandt auf eine elektronische Analoguhr mit drehbarer Zeiteinstellkrone (20), dadurch gekennzeichnet, daß der erste (3) und der zweite (22) drehbare Nocken von der Krone während der Zeiteinstellung der Uhr zur Drehung angetrieben sind.

**Claims**

1. Circuit for shaping a signal (Sx) produced by a contact (X), said signal being in either of first and second states, one state corresponding to the open position of the contaot and the other state corresponding to the closed state thereof, said contact being liable to bounce as it switches from one position to the other, said circuit comprising:

means (11) for producing a reference signal (Sf) made up of a succession of pulses, the repetition frequency of the pulses being greater than the frequency with which the contact's (X) position changes;

means (13) for counting said pulses;

means (10) for causing said pulses to be applied to the counting means when the signal (Sx) from the contact (X) is in its first state, and for causing such application of the pulses to be interrupted when said signal is in its second state;

means (14) for resetting the counting means when the signal (Sx) from the contact (X) is in its second state; and

means (Q13) for producing an output signal when the number of pulses counted by the counting means reaches a predetermined value, characterized in that the means (11) for producing said reference signal (Sf) include means (20 to 25, Z) for increasing and decreasing the repetition frequency of this signal's pulses when the frequenoy with which said contact's position changes inorease and decrease respectively.

2. Circuit as in Claim 1, characterized in that said contact (X) is controlled by a first rotary cam (3) and said means (11) for producing said reference signal (Sf) include a second rotary cam (22), that is kinematically associated for rotation with the first cam, and a detector contact (Z) that is controlled by the second cam and arranged to supply said reference signal (Sf).

3. Circuit as in claim 2, in use in an analog electronic watch having a rotatable time-setting crown (20), characterized in that said first (3) and second (22) cams are rotatably driven by said crown while the watch is time-set.

EP 0 274 035 B1

Fig. 1

Fig. 2

Fig. 3